# EUROPEAN PATENT SPECIFICATION

(11) **EP 3 029 831 B1**
(45) Date of publication and mention of the grant of the patent: **25.07.2018**
(21) Application number: 14196607.7
(22) Date of filing: 05.12.2014
(51) Int. Cl.: H03K 5/08, G11C 29/02, H03K 19/0185

(54) **Process skew resilient digital CMOS circuit**
Verfahrensversatzflexible digitale CMOS-Schaltung
Circuit CMOS numérique résistant à un désalignement de processus

(43) Date of publication of application: 08.06.2016
(73) Proprietor: Stichting IMEC Nederland, 5656 AE Eindhoven (NL)
(72) Inventor: Gemmeke, Tobias, B-3001 Leuven (BE)
(74) Representative: Gevers Patents

(56) References cited:
- US-A1- 2012 250 734
- US-B1- 6 670 836
- US-B1- 8 004 330

## Description

### Technical field

The present disclosure relates to digital CMOS circuits and more specifically to a process skew resilient digital CMOS circuit arrangement by which performance mismatch can be compensated.

### Background art

Advanced semiconductor fabrication techniques have resulted in the fabrication of devices, such as transistors, with continually decreasing feature sizes having a substantial amount of so called process variations. These process variations are due to the inability of accurately printing geometrical features and the inability to correctly control the diffusion of dopants. The presence of process variations translates to variations in key electrical parameters of the devices, which in turn leads to variations in the electrical performance of the fabricated devices as shown for example in US-A-6670836 and US-A-2012/0250734.

Process variations of the fabricated devices may be analysed using the process corners technique, which represent the extremes of these parameter variations within which the fabricated device must function correctly. The process variations using the process corners analysis technique may be differentiated between so called straight corners and skewed corners. Using the example of a CMOS circuit device designed using NMOS and PMOS transistors, the straight corners refer to process variations where both NMOS and PMOS transistors experience similar changes in device performance, e.g slow-slow, fast-fast, typical-typical. On the other hand, using the same example, in the skewed corners the NMOS and PMOS transistors experience opposite changes in device performance, e.g slow-fast, fast-slow, etc. A CMOS circuit device operating in skewed corners may lead to imbalanced timing paths and reduced operating noise margins, which may lead to inefficient implementations and ultimately limit the voltage scaling potential. For example, an inverter CMOS circuit operating in skewed corners may experience a delay mismatch between the rising and falling transitions of the inverter output due to the performance mismatch between the NMOS and PMOS transistors.

Current CMOS design techniques compensate the effects of process variations in CMOS circuit devices operating in skewed corners using a biasing technique whereby the bulk terminal connection of the transistor is biased to a predetermined voltage level so as to adjust the performance of the NMOS and PMOS devices. However, such solution substantially increases the power consumption requirements of the CMOS devices, which is an undesirable effect in the design of low-power digital circuits. Moreover, new CMOS devices, such as finFET or tunnel FET devices, do not feature an explicit bulk terminal thus their performance cannot be adjusted using the biasing technique.

In the absence of a bulk terminal connection the effects of process variation in CMOS devices operating in skewed corners may be compensated by increasing the size of the transistors. For example, in a 90nm CMOS process technology a PMOS/NMOS width ratio of 11 may be necessary for achieving best noise margin at low-voltage. However, increasing the size of the transistors results in a substantial increase of the area overhead and power consumption of the digital circuit, which is undesirable for the design of high density and low power digital circuits.

### Summary of the disclosure

It is an aim of the present disclosure to provide a digital CMOS circuit arrangement in which the effects of process variation in digital CMOS circuits operating in skewed corners may be compensated in an alternative way.

This aim is achieved according to the disclosure with the digital CMOS circuit arrangement showing the technical characteristics of the first independent claim.

More in particular according to embodiments of the present disclosure a digital CMOS circuit arrangement is provided. The digital CMOS circuit arrangement is provided with at least one pull-up circuit, which comprises at least one transistor of a first type, and which is operable between an on-state and an off-state based on a predetermined voltage level supplied to a gate terminal of the at least one first type transistor. The at least one pull-up circuit is arranged when the at least one first type transistor is in the on-state to switch an output node of the digital CMOS circuit arrangement from a first voltage level to a second voltage level within a rising transition delay. The digital CMOS circuit arrangement is further provided with at least one pull-down circuit, which comprises at least one transistor of a second type different from the first type, and which is operable between an on-state and an off-state based on a predetermined voltage level supplied to a gate terminal of the at least one second type transistor. The at least one pull-down circuit is arranged when the at least one second type transistor is in the on-state to switch the voltage level of the output node of the digital CMOS circuit arrangement from the second voltage level to the first voltage level within a falling transition delay. The first and second types are either P-type or N-type.

Performance mismatch between the first and second type transistors may arise due to the effects of process variation, which would cause the digital CMOS circuit arrangement to operate in skewed corners.

The first and second type transistors have drain-source paths which are serially connected to each other with an output node of the digital circuit being provided between the at least one pull-up circuit and the at least one pull-down circuit. For example, the drain terminal of the first type transistor may be connected to the drain terminal of the second type transistor. The digital CMOS circuit arrangement further comprises at least one performance matching transistor, which is either at least one transistor of the first type provided in the at least one pull-down circuit and having a drain-source path serially connected between the drain-source of the at least one second type transistor and the output node, or at least one transistor of the second type provided in the at least one pull-up circuit and having a source-drain path serially connected between that of the first type transistor and the output node. For example, the performance matching transistor may be provided between the first type and second type transistors. A biasing means connected to a gate terminal of each of the at least one performance matching transistors is provided. The biasing means is arranged for supplying a predetermined voltage to the gate terminal for biasing the at least one performance matching transistor such that the at least one performance matching transistor compensates effects of process variation and causes the at least one pull-up circuit and the at least one pull-down circuit to experience a same process skew.

It has been found that the use of a performance matching transistor can overcome or reduce the need for compensating the effects of process variation by means of biasing or transistor sizing and provide an alternative way to, ensure reliable device operation for digital CMOS devices operating in skewed process corners. The introduction of the performance matching transistor in the digital CMOS circuit arrangement ensures that the pull-up and pull-down circuits experience the same process skew. Therefore, connecting the performance matching transistor in series with the first and second type transistors ensures that the pull-up path follows the same process variation trend, either slow or fast, as the pull-down path. As a result, the introduction of the performance matching transistor can cause the digital CMOS device to operate in the straight corners instead of the skewed corners so that the first type and second type transistors experience similar changes in device performance, e.g slow-slow, fast-fast, etc, which may lead to the development of process skew resilient logic families.

According to embodiments of the present disclosure, the biasing means may be arranged for supplying a predetermined fixed voltage to the gate terminal of the performance matching transistor so that the performance matching transistor is maintained in the on-state. This may have as a result that the operation of the digital CMOS circuit may be better controlled since in this configuration the on-current for the pull-up and pull-down paths are determined by the performance matching transistor rather than the transistors of the pull-up and pull-down circuits. Furthermore, the fixed voltage may be supplied directly from the power supply of the circuit, e.g VDD or VSS, thereby minimising the need for providing additional inputs for supplying the biasing voltage. Moreover, in the case where an additional input is provided, the fixed voltage may be regulated so as to ensure better compensation of the process variation effects. For example, this may be achieved by providing a control voltage to the performance matching transistor, which may be adapted based on the parametric variations determined by the manufacturing process, supply voltage variations, or temperature.

According to embodiments of the present disclosure, the biasing means may comprise an inverter circuit the output of which is connected to the gate terminal of at least one performance matching transistor. The use of an inverter to control the switching activity of the matching performance transistor may improve the on to off current ratio of the corresponding pull-up and pull-down circuits. As a result, the use of the inverter may greatly simplify the process of identifying the optimal width ratio between the different transistors of the digital CMOS circuit. This is because, in this configuration the on and off-currents of the pull-up and pull-down paths can be controlled by means of the inverter. As a result, a better on-to-off current ratio can be achieved between the pull-up and pull-down network by controlling both transitions between on and off states. Therefore, by controlling both the on and off-currents of the pull-up and pull-down paths the process of identifying the optimal width ratio for the transistors in the pull-down and pull-up path is greatly simplified.

According to embodiments of the present invention, the size, e.g the transistor width and/or length, ratio between the first and second type transistors may be chosen such that a predetermined device performance is achieved in combination with the presence of the performance matching transistor. For example, the width of the first type transistor may be at least equal to the size of the second type transistor, which ensures low area overhead of the digital CMOS circuit. The size of the first type transistor may be at most three time the size of the second type transistor so as to ensure faster device performance. This size relationship between the first and second type transistors is achievable due to the presence of the performance matching transistor.

### Brief description of the drawings

The disclosure will be further elucidated by means of the following description and the appended figures.
Figures 1 shows an example of a digital CMOS circuit according to prior art.
Figures 2 to 8 show examples of digital CMOS circuits according to embodiments of the present disclosure
Figures 9 and 10 show examples of sizing ratios between pull-up and pull-down transistors according to embodiments of the present invention.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

As used herein, with "transistor size" it is intended to mean the area occupied by the transistor designed in a specific process technology. The size of the transistor is defined by its dimensions, e.g width, length, or height, which can be adapted to meet a predetermine electrical performance.

As used herein, with "size ratio" it is intended to mean the transistor size comparison between NMOS and PMOS transistors of a digital CMOS circuits.

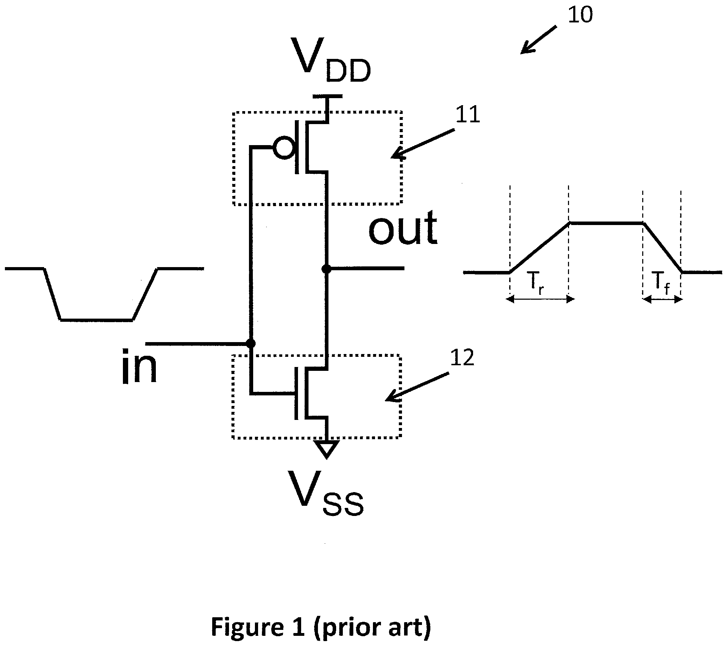

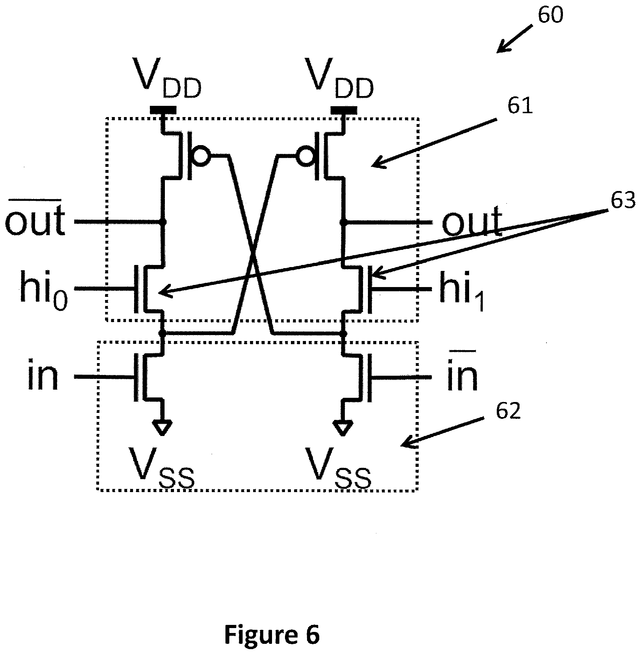

Embodiments of the present disclosure may be exemplified with the aid of the exemplified digital CMOS circuits shown in figures 1 to 10.

Figure 1 show an example of a prior art digital CMOS circuit device 10 comprising a pull-up circuit 11 and a pull-down circuit 12 each respectively comprising at least one first type transistor, e.g PMOS, and at least one second type transistor, e.g NMOS transistor, the gate terminals of which are connected to a common input node. The pull-up 11 and pull-down 12 circuits are operable between an on-state and an off-state depending on the voltage level supplied to the gate terminal of the corresponding first and second type transistors. For example, in the case of a CMOS inverter the pull-up circuit 11 may be activated by supplying in the gate terminal of the PMOS transistor a first voltage level, e.g a low voltage equal to the VSS voltage, while the pull-down 12 network may be activated by supplying to the gate terminal of the NMOS transistor a second voltage level, e.g a high voltage level equal to the VDD voltage. Depending on which one of the pull-up 11 or pull-down 12 circuits is activated the voltage at the output node will switch to the corresponding voltage level within a predetermined transition delay. For example, in the case where a low voltage level is supplied to the input node, the pull-up circuit 11 will be activated causing the voltage at the output node to switch from a low voltage level to a high voltage level within a rising transition delay Tr. In the case where the pull-down circuit 12 is activated instead, the output voltage at the output node will switch from a high voltage level to a low voltage level within a falling transition delay Tf. In a CMOS digital circuit operating in straight process corners, e.g slow-slow, fast-fast, etc, the rising Tr and falling Tf transition delays may be substantially equal since the transistors in the pull-up 11 and pull-down 12 circuits experience same changes in the electrical performance. However, in the case where the CMOS circuit 10 operates in the skewed process corners the rising Tr and falling Tf transition delays may not be equal due to the electrical performance mismatch between the transistors in the pull-up 11 and pull-down 12 circuits, as shown in figure 1. A CMOS circuit device operating in skewed corners may lead to imbalanced timing paths and reduced operating noise margins, which may lead to inefficient implementations and ultimately limit the voltage scaling potential.

To compensate the effects of process variation in digital CMOS circuits operating in skewed corners the CMOS circuit arrangement of the present disclosure may be used. According to embodiments of the present disclosure a performance matching transistor may be serially connected to the at least one first type transistor, e.g PMOS, of the pull-up circuit and the at least one second type transistor, e.g NMOS, of the pull-down circuit. The gate terminal of the performance matching transistor may be connected to biasing means arranged for biasing the at least one performance matching transistor in such a way so as to compensate the performance mismatch between the at least one first and second type transistors. As a result, with the digital CMOS circuit arrangement of the present invention the process variation effects of a CMOS circuit operating in skewed corners may be compensated without the need for explicit bulk terminal connection or by substantially increasing the size, e.g width and/or length, of the transistors in the pull-up and pull-down circuits.

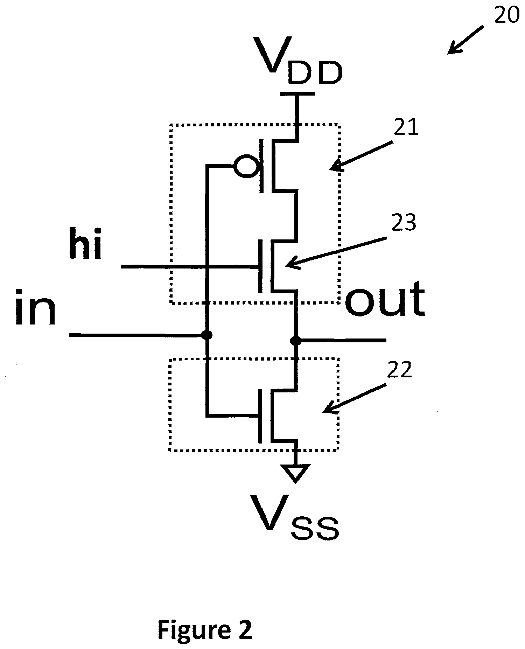

Figure 2 shows an example of a digital CMOS circuit 20 according to embodiments of the present disclosure. In this case a CMOS inverter 20 operating in a similar manner to the CMOS inverter of figure 1 may be used as an example. The CMOS inverter 20 may be implemented as a skew resilient logic so as to compensate the effects of process variation by matching the electrical performance of the pull-down circuit 22 with the pull-up circuit 21. This may be achieved by providing a performance matching transistor 23 of an N-type in the pull-up circuit 21 between the PMOS transistor and the output node of the CMOS inverter 20. The NMOS performance matching transistor 23 in the pull-up path may cause the pull-up circuit 21 to experience the same process skew as the pull-down circuit 22, thereby causing the pull-up path to follow the same process variation trend, either slow or fast, as the pull-down path. The gate terminal of the NMOS performance matching transistor 23 may be connected to biasing means arranged for supplying a fixed voltage, e.g VDD, so that the performance matching transistor may be maintained in the on-state. For example, the fixed voltage may be supplied directly from the power supply of the circuit, e.g VDD or VSS, thereby minimising the need for providing additional inputs for supplying the biasing voltage.

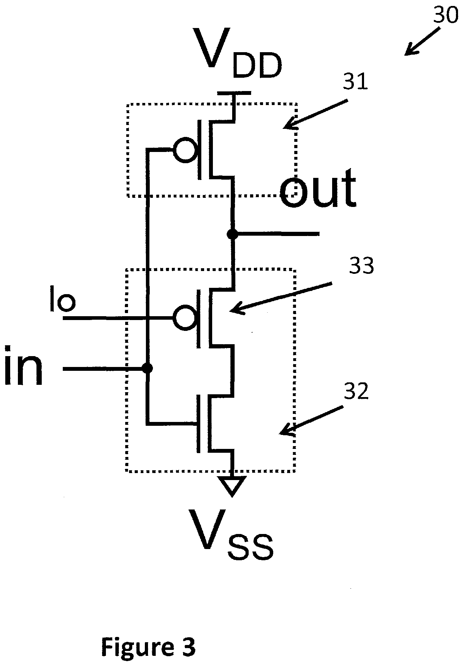

According to embodiments of the present disclosure, in order to match the electrical performance of the pull-up circuit with the pull-down circuit, a PMOS performance matching transistor may be provided in the pull-down circuit of a digital CMOS device. Figure 3 shows a digital CMOS device, such as a CMOS inverter 30 operating in a similar manner to the one presented in figure 2. The CMOS inverter 30 may be implemented as a skew resilient logic so as to compensate the effects of process variation by matching the electrical performance of the pull-up circuit 31 with the pull-down circuit 32. This may be achieved by providing a performance matching transistor 33 of a P-type in the pull-down circuit 32 between the NMOS transistor and the output node. The PMOS performance matching transistor 33 in the pull-down path may cause the pull-down circuit 32 to experience the same process skew as the pull-up circuit 31, thereby causing the pull-down path to follow the same process variation trend, either slow or fast, as the pull-up path. The gate terminal of the PMOS performance matching transistor 33 may be connected to biasing means arranged for supplying a fixed voltage, e.g Vss, so that the performance matching transistor 33 may be maintained in the on-state. For example, the fixed voltage may be supplied directly from the power supply of the circuit, e.g VDD or VSS, thereby minimising the need for providing additional inputs for supplying the biasing voltage.

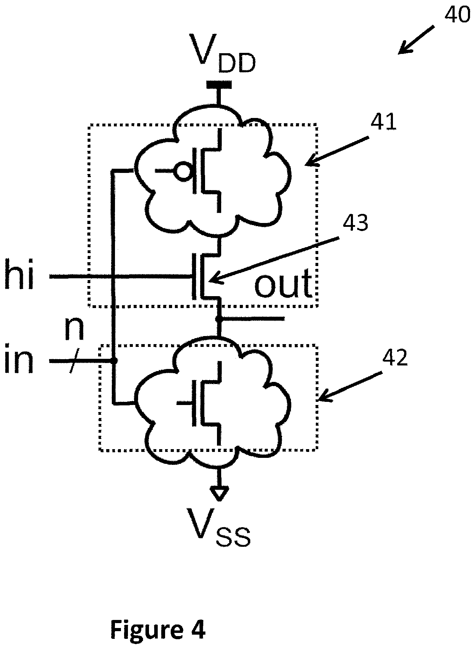

According to embodiments of the present invention, the digital CMOS circuit arrangement according to the present disclosure may be used with digital CMOS circuits having multiple inputs for matching the electrical performance of the pull-down circuit with the pull-up circuit and vice versa, as shown in figure 4.

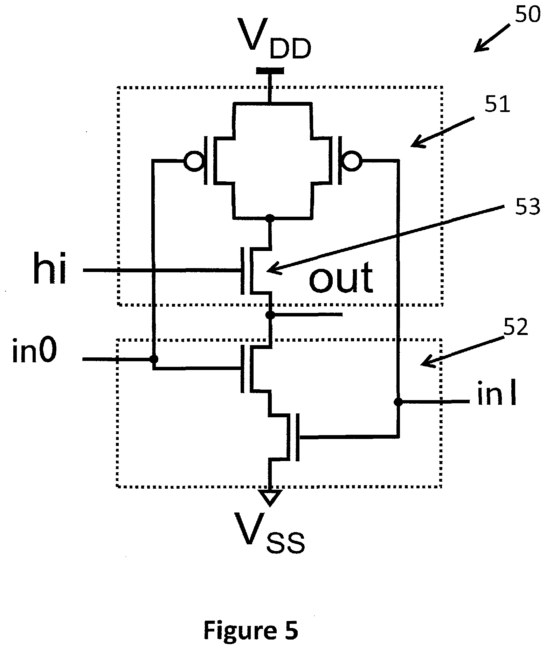

For example, as shown in figure 5, a two-input CMOS AND logic gate 50 may be implemented as a skew resilient logic so as to compensate the effects of process variation by matching the electrical performance of the pull-down circuit 52 with the pull-up circuit 51. This may be achieved by providing at least one NMOS type performance matching transistor 53 between the PMOS transistors of the pull-up circuit 51 and the output node. For example, the NMOS performance matching transistor 53 may be serially connected to the PMOS transistors of the pull-up circuit 51 and to the NMOS transistors of the pull-down circuit 52. In the exemplified circuit arrangement shown in figure 5, the drain terminal of the at least one NMOS performance matching transistor 53 may be connected to the drain terminals of the PMOS transistors of the pull-up circuit 51, while the source terminal of the NMOS performance matching transistor 53 may be connected to the drain terminal of at least one of the NMOS transistor of the pull-down circuit 52. The NMOS performance matching transistor 53 in the pull-up path may cause the pull-up circuit 51 to experience the same process skew as the pull-down circuit 52, thereby causing the pull-up path to follow the same process variation trend, either slow or fast, as the pull-down path. The gate terminal of the NMOS performance matching transistor 53 may be connected to biasing means arranged for supplying a fixed voltage, e.g VDD, so that the performance matching transistor may be maintained in the on-state. For example, the fixed voltage may be supplied directly from the power supply of the circuit, e.g VDD or VSS, thereby minimising the need for providing additional inputs for supplying the biasing voltage. It should be noted, that similarly to previous embodiments the CMOS AND logic gate 50 may be implemented as a skew resilient logic so as to compensate the effects of process variation by matching the electrical performance of the pull-up circuit 51 with the pull-down circuit 52 by providing a performance matching transistor 33 of a P-type in the pull-down circuit 52 between the NMOS transistors and the output node.

According to embodiments of the present invention, a Cascode Voltage Switch Logic (CVSL) 60 may be implemented as a skew resilient logic so as to compensate the effects of process variation by matching the electrical performance of the pull-down circuit 62 with the pull-up circuit 61. In this case, two NMOS performance matching transistors 63 may be provided in the pull-path, which may be serially connected to the PMOS transistors in the pull-up path. In this configuration, the two NMOS performance matching transistors 63 in the pull-up path will experience the same process skew as the NMOS transistors in the pull-down circuit 62 causing the pull-up path to follow the same process corner trend, slow-slow or fast-fast, as the pull-down path. The gate terminal of each of the NMOS performance matching transistor 63 may be connected to biasing means arranged for supplying a fixed voltage, e.g VDD, so that the performance matching transistor may be maintained in the on-state. For example, the fixed voltage may be supplied directly from the power supply of the circuit, e.g VDD or VSS, thereby minimising the need for providing additional inputs for supplying the biasing voltage. It should be noted, that similarly to previous embodiments the CSVL circuit 60 may be implemented as a skew resilient logic so as to compensate the effects of process variation by matching the electrical performance of the pull-up circuit 61 with the pull-down circuit 62 by providing performance matching transistors 63 of a P-type in the pull-down circuit 62, which may be serially connected to the NMOS transistors of the pull-down circuit 62.

According to embodiments of the present disclosure, the present disclosure may be used for the development of skew resilient CMOS logic families, such as logic gates or other circuits, having lower area overhead and reduced propagation delay than comparable standard CMOS implementations.

According to embodiments of the present disclosure, the biasing means may be provided with an inverter the output of which may be connected to the gate terminal of the performance matching transistor. The inverter may be used to control the switching activity of the matching performance transistor so as to improve the on to off current ratio of the corresponding pull-up and pull-down circuits. For example, the inverter circuit may be used for power gating the digital CMOS circuit so as achieve a leakage power reduction, which may lead to the scaling of the operating voltage and/or process skew of the digital CMOS circuit due to the improved on to off ratio.

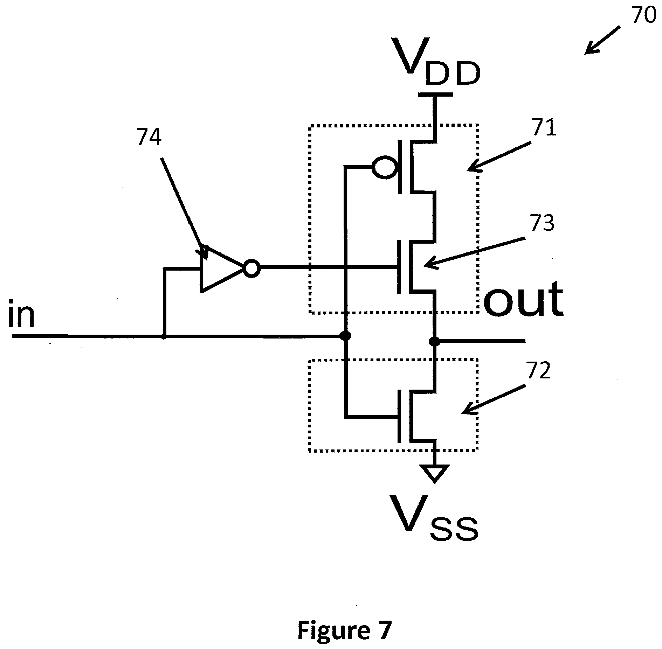

For example, as shown in figure 7, a CMOS inverter 70 may be implemented as a skew resilient logic so as to compensate the effects of process variation by matching the electrical performance of the pull-down circuit 72 with the pull-up circuit 71. As previously discussed, this may be achieved by providing a performance matching transistor 73 of an N-type in the pull-up circuit 71 between the PMOS transistor and the output node. The NMOS performance matching transistor 73 in the pull-up path may cause the pull-up circuit 71 to experience the same process skew as the pull-down circuit 72, thereby causing the pull-up path to follow the same process variation trend, either slow or fast, as the pull-down path. The gate terminal of the NMOS performance matching transistor 73 may be connected to the output of an inverter 74, which may be part of the biasing means, the input of which may connected to the gate terminal of at least one of the transistors in the pull-up 71 or pull-down circuit 72. For example, as shown in figure 7, the input of the inverter 74 is connected to the input node of the CMOS inverter 70, so that when the input voltage supplied to the input node of the CMOS inverter 70 switches from a high voltage, e.g VDD, to a low voltage, e.g Vss, causes the NMOS performance matching transistor 73 to switch from the off-state to the on-state, thereby causing the pull-up path to follow the same process corner trend with that of the pull-down path. In contrast, when the input voltage supplied to the input node of the CMOS inverter 70 switches from a low voltage, e.g Vss, to a high voltage, e.g VDD, causes the NMOS performance matching transistor 73 to switch from the on-state to the off-state, thereby reducing the leakage power of the CMOS inverter 70, which may lead to the scaling of the operating voltage and/or process skew due to the improved on to off current ratio.

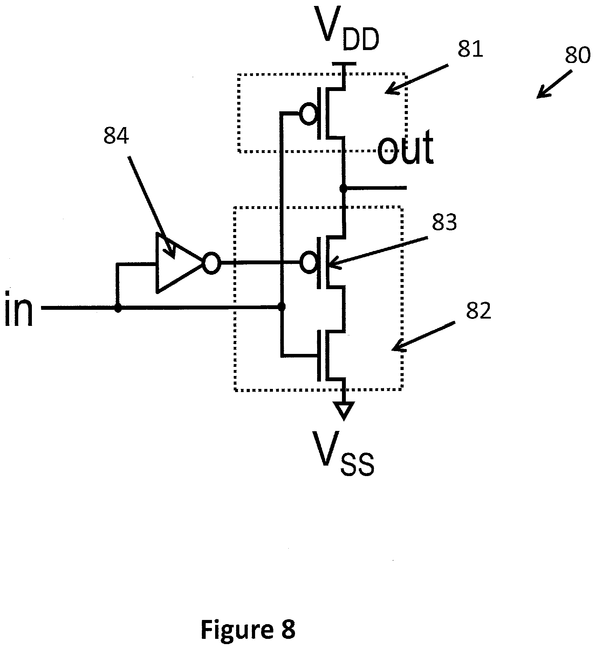

Similarly, as shown in figure 8, an inverter 84 may be used to control the switching activity of a PMOS performance matching transistor 83 provided in pull-down circuit 82 of a circuit device, such as CMOS inverter 80, implemented as a skew resilient logic so as to compensate the effects of process variation by matching the electrical performance of the pull-up circuit 81 with the pull-down circuit 82. In this case, the gate terminal of the PMOS performance matching transistor 83 may be connected to the output of an inverter 84, which may be part of the biasing means, the input of which may connected to the gate terminal of at least one of the transistors in the pull-up 81 or pull-down circuit 82. For example, as shown in figure 8, the input of the inverter 84 is connected to the input node of the CMOS inverter 80, so that when the input voltage supplied to the input node of the CMOS inverter 80 switches from a low voltage, e.g Vss, to a high voltage, e.g VDD, causes the PMOS performance matching transistor 83 to switch from the off-state to the on-state, thereby causing the pull-down path to follow the same process corner trend with that of the pull-up path. In contrast, when the input voltage supplied to the input node of the CMOS inverter 80 switches from a high voltage, e.g VDD, to a low voltage, e.g Vss, causes the PMOS performance matching transistor 83 to switch from the on-state to the off-state, thereby reducing the leakage power of the CMOS inverter 80, which may lead to the scaling of the operating voltage and/or process skew due to the improved on to off current ratio

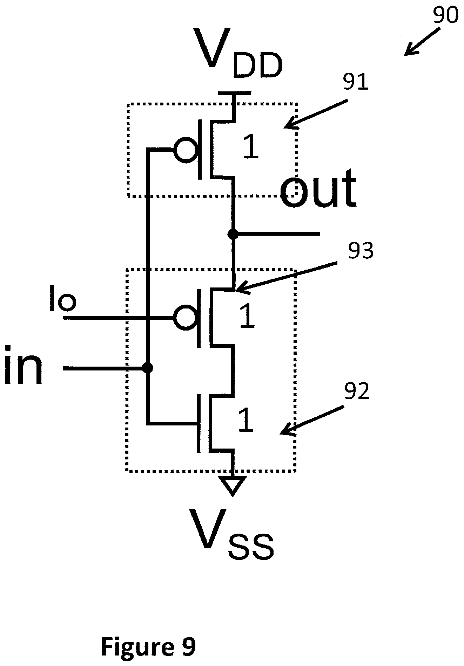

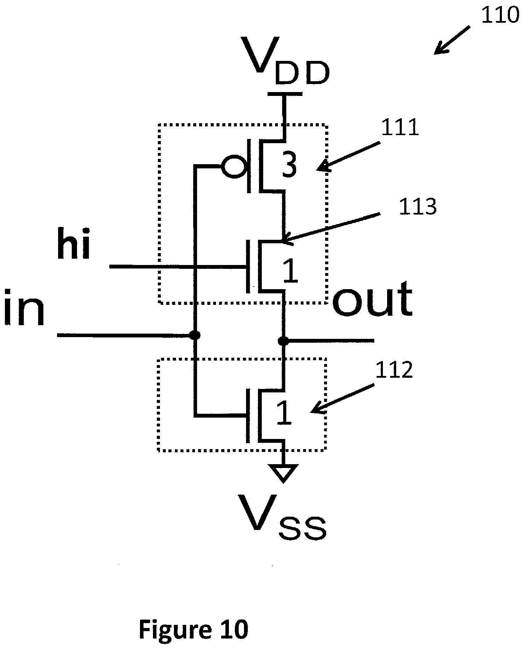

According to embodiments of the present disclosure, the use of the inverter circuit to control the switching activity of the performance matching transistor greatly reduces the sizing requirements of the transistors in the pull-up and pull-down circuits for achieving a predetermine device performance. This is due to the improved on to off current ratio, which may result in the size ratio between the transistors of the pull-up and pull-down circuit being smaller than comparable standard CMOS implementations. This is because, in this configuration the on and off-current of the pull-up and pull-down paths can be controlled by means of the inverter. Therefore, by controlling both the on and off-currents of the pull-up and pull-down paths the process of identifying the optimal width ratio for the transistors in the pull-down and pull-up path is greatly simplified. For example, the size, e.g the transistor width and/or length, ratio between the transistors of the pull-up and pull-down circuits may be chosen such that a predetermined device performance may be achieved in combination with the presence of the performance matching transistor. For example, as shown in Figure 9, a CMOS digital circuit 90, such as a CMOS inverter may be implemented as a skew resilient logic according to embodiments of the present invention, so as to compensate the effects of process variation by matching the electrical performance of the pull-up circuit 91 with the pull-down circuit 92, which may be achieved by providing a PMOS performance matching transistor 93 between the at least one NMOS transistor of the pull-down circuit 92 and the output node of the CMOS digital circuit 90. In this case, the transistor sizes for the NMOS and PMOS transistors in digital CMOS circuit may be selected to be equal. In a further example, as shown in Figure 10, a CMOS digital circuit 110, such as a CMOS inverter, may be implemented as a skew resilient logic according to embodiments of the present invention, so as to compensate the effects of process variation by matching the electrical performance of the pull-down circuit 112 with the pull-up circuit 111 by providing a NMOS performance matching transistor 113 between the PMOS transistors of the pull-up circuit 111 and the output node of the CMOS digital circuit 110. In this case, the size of the PMOS transistors of the digital CMOS circuit 110 may be at most three times the size selected for the NMOS transistors of the digital CMOS circuit 110.

According to embodiments of the present disclosure, digital CMOS circuits may be implemented with transistors that have no explicit bulk terminal connections. For example, the transistors in the pull-up and pull-down circuits and the at least one performance matching transistor may be multi-gate transistors such as finFET, tunnel field-effect transistors, or the like.

## Claims

1. A digital CMOS circuit (20, 30, 40, 50, 60, 70, 80, 90, 110) comprising:
at least one pull-up circuit (21, 31, 41, 51, 61, 71, 81, 91, 111) comprising at least one transistor of a first type, which is operable between an on-state and an off-state based on a predetermined voltage level supplied to a gate terminal of the at least one first type transistor, wherein the at least one pull-up circuit (21, 31, 41, 51, 61, 71, 81, 91, 111) is arranged when the at least one first type transistor is in the on-state to switch an output node of the digital CMOS circuit (20, 30, 40, 50, 60, 70, 80, 90, 110) from a first voltage level to a second voltage level within a rising transition delay;
at least one pull-down circuit (22, 32, 42, 52, 62, 72, 82, 92, 112) comprising at least one transistor of a second type different from the first type, which is operable between an on-state and an off-state based on a predetermined voltage level supplied to a gate terminal of the at least one second type transistor, wherein the at least one pull-down circuit (22, 32, 42, 52, 62, 72, 82, 92, 112) is arranged when the at least one second type transistor is in the on-state to switch the voltage level of the output node of the digital CMOS circuit (20, 30, 40, 50, 60, 70, 80, 90, 110) from the second voltage level to the first voltage level within a falling transition delay; and
wherein the first and second types are either P-type or N-type; and
wherein the first and second type transistors have drain-source paths which are serially connected to each other, with an output node of the digital circuit being provided between the at least one pull-up circuit and the at least one pull-down circuit;
**characterised in that** the digital CMOS circuit (20, 30, 40, 50, 60, 70, 80, 90, 110) comprises:
at least one performance matching transistor (23, 33, 43, 53, 63, 73, 83, 93, 113) being either at least one transistor of the first type provided in the at least one pull-down circuit and having a drain-source path serially connected between that of the second type transistors and the output node, or at least one transistor of the second type provided in the at least one pull-up circuit and having a drain-source path serially connected between that of the first type transistors and the output node; and
a biasing means connected to a gate terminal of each of the at least one performance matching transistor and arranged for supplying a predetermined voltage to the gate terminal for biasing the at least one performance matching transistor (23, 33, 43, 53, 63, 73, 83, 93, 113) such that the at least one performance matching transistor compensates effects of process variation and causes the at least one pull-up circuit and the at least one pull-down circuit to experience a same process skew.

2. The digital CMOS circuit (20, 30, 40, 50, 60, 70, 80, 90, 110) of claim 1, wherein the biasing means is arranged for supplying a fixed voltage to the gate terminal of the performance matching transistor (23, 33, 43, 53, 63, 73, 83, 93, 113) so as to maintain the performance matching transistor (23, 33, 43, 53, 63, 73, 83, 93, 113) in the on-state.

3. The digital CMOS circuit (20, 30, 40, 50, 60, 70, 80, 90, 110) of claim 1 or 2, wherein the biasing means comprises an inverter circuit (74, 84) the output of which is connected to the gate terminal of at least one performance matching transistor (74, 84) and its input is connected to at least one of the gate terminals of the first and second type transistors.

4. The digital CMOS circuit (20, 30, 40, 50, 60, 70, 80, 90, 110) of any one of claims 1 to 3, wherein the size ratio between the first and second type transistors is chosen such that in combination with the performance matching transistor a predetermined device performance is achieved.

5. The digital CMOS circuit (20, 30, 40, 50, 60, 70, 80, 90, 110) of any one of the preceding claims, wherein the size of the first type transistor is at least equal to the size of the second type transistor.

6. The digital CMOS circuit (20, 30, 40, 50, 60, 70, 80, 90, 110) of any one claims 1 to 4, wherein the size of the first type transistor is at most three time the size of the second type transistor.

7. The digital CMOS circuit (20, 30, 40, 50, 60, 70, 80, 90, 110) of any one of the preceding claims, wherein the first type is P-type transistor and the second type is N-type.

8. The digital CMOS circuit (20, 30, 40, 50, 60, 70, 80, 90, 110) of any one of the preceding claims, wherein the first type transistor, the second type transistor, and the at least one performance matching transistor (23, 33, 43, 53, 63, 73, 83, 93, 113) are transistors with no bulk terminal such as multi-gate transistors or tunnel field-effect transistors (TFET).

9. A digital system comprising a digital CMOS circuit (20, 30, 40, 50, 60, 70, 80, 90, 110) according to claims 1 to 8.

## Patentansprüche

1. Eine digitale CMOS-Schaltung (20, 30, 40, 50, 60, 70, 80, 90, 110), welche Folgendes umfasst:
zumindest eine Pull-up-Schaltung (21, 31, 41, 51, 61, 71, 81, 91, 111), welche zumindest einen Transistor eines ersten Typs umfasst, der bedienbar ist zwischen einem Ein-Zustand und einem Aus-Zustand basierend auf einem vorbestimmten Spannungsniveau, welches an einen Gate-Terminal des zumindest einen ersten Typs Transistor geliefert wird, wobei die zumindest eine Pull-up-Schaltung (21, 31, 41, 51, 61, 71, 81, 91, 111) angeordnet ist, um, wenn der zumindest eine erste Typ Transistor im Ein-Zustand ist, einen Ausgabeknoten der digitalen CMOS-Schaltung (20, 30, 40, 50, 60, 70, 80, 90, 110) von einem ersten Spannungsniveau auf ein zweites Spannungsniveau innerhalb einer ansteigenden Übergangsverzögerung zu schalten;
zumindest eine Pull-down-Schaltung (22, 32, 42, 52, 62, 72, 82, 92, 112), welche zumindest einen Transistor eines zweiten, vom ersten Typ unterschiedlichen Typs umfasst, der bedienbar ist zwischen einem Ein-Zustand und einem Aus-Zustand basierend auf einem vorbestimmten Spannungsniveau, welches an einen Gate-Terminal des zumindest einen zweiten Typs Transistor geliefert wird, wobei die zumindest eine Pull-down-Schaltung (22, 32, 42, 52, 62, 72, 82, 92, 112) angeordnet ist, um, wenn der zumindest eine zweite Typ Transistor im Ein-Zustand ist, das Spannungsniveau des Ausgabeknotens der digitalen CMOS-Schaltung (20, 30, 40, 50, 60, 70, 80, 90, 110) vom zweiten Spannungsniveau auf das erste Spannungsniveau innerhalb einer abfallenden Übergangsverzögerung zu schalten; und
wobei der erste und der zweite Typ entweder P-Typ oder N-Typ sind; und
wobei der erste und der zweite Typ Transistoren Drain-Source-Wege haben, welche seriell miteinander verbunden sind, wobei ein Ausgabeknoten der digitalen Schaltung zwischen der zumindest einen Pull-up-Schaltung und der zumindest einen Pull-down-Schaltung bereitgestellt ist;
**dadurch gekennzeichnet, dass** die digitale CMOS-Schaltung (20, 30, 40, 50, 60, 70, 80, 90, 110), Folgendes umfasst:
zumindest einen Leistungsanpassungstransistor (23, 33, 43, 53, 63, 73, 83, 93, 113), der entweder zumindest ein Transistor des ersten Typs ist, welcher in der zumindest einen Pull-down-Schaltung bereitgestellt ist und einen Drain-Source-Weg hat, der seriell zwischen jenem der Transistoren des zweiten Typs und dem Ausgabeknoten ist, oder zumindest ein Transistor des zweiten Typs, welcher in der zumindest einen Pull-up-Schaltung bereitgestellt ist und einen Drain-Source-Weg hat, der seriell zwischen jenem der Transistoren des ersten Typs und dem Ausgabeknoten verbunden ist; und
ein Vorspannungsmittel verbunden mit einem Gate-Terminal jedes des zumindest einen Leistungsanpassungstransistors und angeordnet, um eine vorbestimmte Spannung an den Gate-Terminal zu liefern, um den zumindest einen Leistungsanpassungstransistor (23, 33, 43, 53, 63, 73, 83, 93, 113) so vorzuspannen, dass der zumindest eine Leistungsanpassungstransistor die Effekte von Prozessstreuung kompensiert und bewirkt, dass die zumindest eine Pull-up-Schaltung und die zumindest eine Pull-down-Schaltung einen gleichen Verfahrensversatz erfahren.

2. Die digitale CMOS-Schaltung (20, 30, 40, 50, 60, 70, 80, 90, 110) nach Anspruch 1, wobei das Vorspannungsmittel angeordnet ist, um eine festgelegte Spannung an den Gate-Terminal des Leistungsanpassungstransistors (23, 33, 43, 53, 63, 73, 83, 93, 113) zu liefern, sodass sich der Leistungsanpassungstransistor (23, 33, 43, 53, 63, 73, 83, 93, 113) im Ein-Zustand befindet.

3. Die digitale CMOS-Schaltung (20, 30, 40, 50, 60, 70, 80, 90, 110) nach Anspruch 1 oder 2, wobei das Vorspannungsmittel eine Inverterschaltung (74, 84) umfasst, deren Output mit dem Gate-Terminal des zumindest einen Leistungsanpassungstransistors (74, 84) verbunden ist und deren Input mit zumindest einem der Gate-Terminals der Transistoren des ersten und zweiten Typs verbunden ist.

4. Die digitale CMOS-Schaltung (20, 30, 40, 50, 60, 70, 80, 90, 110) nach irgendeinem der Ansprüche 1 bis 3, wobei das Größenverhältnis zwischen den Transistoren des ersten und zweiten Typs so gewählt ist, dass in Kombination mit dem Leistungsanpassungstransistor eine vorbestimmte Geräteleistung erreicht wird.

5. Die digitale CMOS-Schaltung (20, 30, 40, 50, 60, 70, 80, 90, 110) nach irgendeinem der vorigen Ansprüche, wobei die Größe des ersten Typs Transistor zumindest gleich wie die Größe des zweiten Typs Transistor ist.

6. Die digitale CMOS-Schaltung (20, 30, 40, 50, 60, 70, 80, 90, 110) nach irgendeinem der Ansprüche 1 bis 4, wobei die Größe des ersten Typs Transistor höchstens dreimal die Größe des zweiten Typs Transistor beträgt.

7. Die digitale CMOS-Schaltung (20, 30, 40, 50, 60, 70, 80, 90, 110) nach irgendeinem der vorigen Ansprüche, wobei der erste Typ ein P-Typ-Transistor und der zweite Typ ein N-Typ ist.

8. Die digitale CMOS-Schaltung (20, 30, 40, 50, 60, 70, 80, 90, 110) nach irgendeinem der vorigen Ansprüche, wobei der erste Typ Transistor, der zweite Typ Transistor, und der zumindest eine Leistungsanpassungstransistor (23, 33, 43, 53, 63, 73, 83, 93, 113) Transistoren ohne Bulk-Terminal sind, wie Multi-Gate-Transistoren oder Tunnel-Feldeffekttransistoren (TFET).

9. Ein digitales System, welches eine digitale CMOS-Schaltung (20, 30, 40, 50, 60, 70, 80, 90, 110) nach den Ansprüchen 1 bis 8 umfasst.

## Revendications

1. Un circuit CMOS numérique (20, 30, 40, 50, 60, 70, 80, 90, 110) comprenant :
au moins un circuit de tirage (21, 31, 41, 51, 61, 71, 81, 91, 111) comprenant au moins un transistor d'un premier type, qui est opérable entre un état activé et un état désactivé sur la base d'un niveau de tension prédéterminé apporté à une borne de grille de l'au moins un transistor de premier type, dans lequel l'au moins un circuit de tirage (21, 31, 41, 51, 61, 71, 81, 91, 111) est agencé quand l'au moins un transistor de premier type est dans l'état activé pour commuter un noeud de sortie du circuit CMOS numérique (20, 30, 40, 50, 60, 70, 80, 90, 110) d'un premier niveau de tension à un deuxième niveau de tension dans un retard de transition croissant ;
au moins un circuit de rappel (22, 32, 42, 52, 62, 72, 82, 92, 112) comprenant au moins un transistor d'un second type différent du premier type, qui est opérable entre un état activé et un état désactivé sur la base d'un niveau de tension prédéterminé apporté à une borne de grille de l'au moins un transistor de second type, dans lequel l'au moins un circuit de rappel (22, 32, 42, 52, 62, 72, 82, 92, 112) est agencé quand l'au moins un transistor de second type est dans l'état activé pour commuter le niveau de tension d'un noeud de sortie du circuit CMOS numérique (20, 30, 40, 50, 60, 70, 80, 90, 110) du second niveau de tension au premier niveau de tension dans un retard de transition décroissant ; et
dans lequel les premier et second types sont soit le type P soit le type N ; et
dans lequel les transistors de premier et second types comportent des chemins de drain-source qui sont connectés entre eux en série, avec un noeud de sortie du circuit numérique étant disposé entre l'au moins un circuit de tirage et l'au moins un circuit de rappel ;
**caractérisé en ce que** le circuit CMOS numérique (20, 30, 40, 50, 60, 70, 80, 90, 110) comprend :
au moins un transistor de correspondance de performance (23, 33, 43, 53, 63, 73, 83, 93, 113) qui est soit au moins un transistor du premier type disposé dans l'au moins un circuit de rappel et ayant un chemin de drain-source connecté en série entre celui des transistors de second type et le noeud de sortie, soit au moins un transistor du second type disposé dans l'au moins un circuit de tirage et ayant un chemin de drain-source connecté en série entre celui des transistors de premier type et le noeud de sortie ; et
un moyen de polarisation connecté à une borne de grille de chacun des au moins un transistor de correspondance de performance et agencé pour apporter une tension prédéterminée à la borne de grille pour polariser l'au moins un transistor de correspondance de performance (23, 33, 43, 53, 63, 73, 83, 93, 113) de telle sorte que l'au moins un transistor de correspondance de performance compense les effets de variation de processus et amène l'au moins un circuit de tirage et l'au moins un circuit de rappel à subir un même biais de processus.

2. Le circuit CMOS numérique (20, 30, 40, 50, 60, 70, 80, 90, 110) selon la revendication 1, dans lequel le moyen de polarisation est agencé pour apporter une tension fixe à la borne de grille du transistor de correspondance de performance (23, 33, 43, 53, 63, 73, 83, 93, 113) de manière à maintenir le transistor de correspondance de performance (23, 33, 43, 53, 63, 73, 83, 93, 113) dans l'état activé.

3. Le circuit CMOS numérique (20, 30, 40, 50, 60, 70, 80, 90, 110) selon la revendication 1 ou 2, dans lequel le moyen de polarisation comprend un circuit onduleur (74, 84) dont la sortie est connectée à la borne de grille d'au moins un transistor de correspondance de performance (74, 84) et son entrée est connectée à au moins une des bornes de grille des transistors de premier et second type.

4. Le circuit CMOS numérique (20, 30, 40, 50, 60, 70, 80, 90, 110) selon l'une quelconque des revendications 1 à 3, dans lequel le rapport de taille entre les transistors de premier et second type est choisi de telle sorte que, en combinaison avec le transistor de correspondance de performance, une performance de dispositif prédéterminée est réalisée.

5. Le circuit CMOS numérique (20, 30, 40, 50, 60, 70, 80, 90, 110) selon l'une quelconque des revendications précédentes, dans lequel la taille du transistor de premier type est au moins égale à la taille du transistor de second type.

6. Le circuit CMOS numérique (20, 30, 40, 50, 60, 70, 80, 90, 110) selon l'une quelconque des revendications 1 à 4, dans lequel la taille du transistor de premier type fait au maximum trois fois la taille du transistor de second type.

7. Le circuit CMOS numérique (20, 30, 40, 50, 60, 70, 80, 90, 110) selon l'une quelconque des revendications précédentes, dans lequel le premier type est un transistor de type P et le second type est le type N.

8. Le circuit CMOS numérique (20, 30, 40, 50, 60, 70, 80, 90, 110) selon l'une quelconque des revendications précédentes, dans lequel le transistor de premier type, le transistor de second type et l'au moins un transistor de correspondance de performance (23, 33, 43, 53, 63, 73, 83, 93, 113) sont des transistors sans borne de masse tels que des transistors à grilles multiples ou des transistors à effet tunnel (TFET).

9. Un système numérique comprenant un circuit CMOS numérique (20, 30, 40, 50, 60, 70, 80, 90, 110) selon les revendications 1 à 8.
